# EUROPEAN PATENT APPLICATION

(11) **EP 0 687 067 A2**
(43) Date of publication of application: **13.12.1995**
(21) Application number: 95108300.5
(22) Date of filing: 30.05.1995
(51) Int. Cl.: H03K 17/082, H03K 17/785

(54) **Short circuit protector for an isolated power MOSFET output stage**

(30) Priority: 06.06.1994 US 254385
(71) Applicant: EATON CORPORATION, Cleveland, Ohio 44114-2584 (US)
(72) Inventor: Flueckiger, Noah, Mequon, Wisconsin 53092 (US); Kalista, Daniel James, Milwaukee, Wisconsin 53207 (US)
(74) Representative: Schwan, Gerhard, Dipl.-Ing.

(57) **Abstract**

An output stage of an electronic device (10) has first and second output terminals (25,30). A current sensing resistor (28) and a conduction path of a metal oxide semiconductor field effect transistor (MOSFET) (24) are connected in series across the output terminals (25,30). An optically isolated MOSFET driver (16) has an output (18) connected to the control electrode and responds to a signal applied to its input by generating a bias voltage that turns on the MOSFET (24). A first transistor (38) has a base electrode coupled by a resistor (32) to a connection (26) between the MOSFET (24) and the current sensing resistor (28), and has an emitter-collector conduction path connected between a node (41) and the second output terminal (30). Another resistor (42) couples the node (41) and the MOSFET (24) control electrode. A second transistor (40) has a base electrode connected to the node (41) and its emitter-collector conduction path connected between the MOSFET (24) control electrode and the base electrode of the first transistor (38).

## Description

### Background Of The Invention

The present invention relates to devices for protecting output transistors from damage during a short circuit, and more particularly to the use of such protection devices in output stages which are optically isolated.

Control circuits for operating various types of mechanisms commonly employ sensors to detect when the mechanism is in one position or another. For example, a piece of manufacturing equipment may have components that move between a number of positions. The control circuit may perform an operation only when a given component is at a defined position or may inhibit an operation if another component is in a specific position. For example, a transport mechanism which is at the end of its path of travel can only be activated to move in one direction. In other instances, operation of equipment is inhibited unless certain safety devices are properly positioned.

Such control systems incorporate sensors to detect the presence or absence of a component at a sensing position. Typically, the sensor provides circuitry for detecting that presence and then closes a switch which applies electricity to a device being controlled. Often the sensor circuit operates at low voltage and switches high voltage in which case the output is isolated from the sensor circuit. The output switch can be a power transistor such as a metal oxide silicon field effect transistor (MOSFET) which is controlled by a photovoltaic MOSFET driver that optically isolates the sensing circuitry from the higher voltage being switched.

If a short circuit occurs in external devices connected to the output switch, a relatively high current can flow which destroys the transistor. Although it is quite common to provide short circuit protection in a wide variety of electrical and electronic circuits, the provision of short circuit protection in an optically isolated MOSFET output stage is not a trivial engineering design. Because a MOSFET requires virtually no gate current, the typical photovoltaic MOSFET driver can provide only a relatively small current (e.g. 20-30 micro-amperes). Conventional short circuit protectors, that are integrated into output stages, can not operate at these low current levels making such protectors impractical for use with photovoltaic MOSFET drivers.

### Summary Of The Invention

An object of the present invention is to protect the output stage of an electronic device against adverse effects of a short circuit occurring in external circuitry connected to the output stage.

Another object is to provide short circuit protection in an optically isolated output stage.

In particular, the short circuit protected output stage comprises first and second output terminals to which the external circuitry is to be connected. A power transistor, such as a MOSFET, has a conduction path coupled in series with a current sensing resistor between the first and second output terminals. An optical isolator has an output that is connected to a control electrode of the power transistor and responds to a signal applied to an input of the optical isolator by producing a positive bias voltage at the output. The optical isolator may be a photovoltaic MOSFET driver.

A latching switch is connected in series with a resistor between a control electrode of the power transistor and the second output terminal. The latching switch has a control terminal coupled to a connection between the power transistor and the current sensing resistor, and is rendered conductive by a voltage across the current sensing resistor exceeding a threshold level. Thereafter the latching switch remains in a conductive state for as long as the optical isolator applies the positive bias voltage to the control electrode of the power transistor.

In the preferred embodiment, the latching switch includes first and second transistors. The first transistor has a base electrode coupled by another resistor to the connection between the metal oxide semiconductor field effect transistor and the current sensing resistor. The emitter-collector conduction path of the first transistor is connected between the node and the second output terminal. The second transistor has a base electrode connected to said node and a second emitter-collector conduction path extends between the control electrode and the base of the first transistor. The combined gain of the first and second transistors is relatively high so that only a small current from the optical isolator is required to maintain the transistors latched in the conductive state.

### Brief Description Of The Drawings

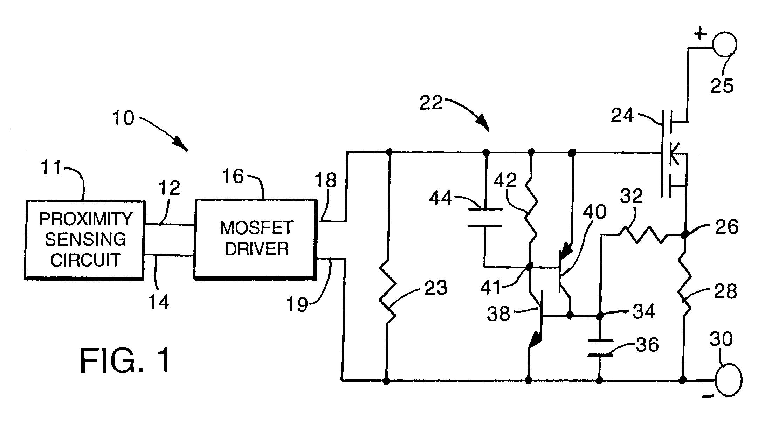

FIGURE 1 is a schematic diagram of a device that has an output stage which incorporates short circuit protection according to the present invention.

### Description Of The Preferred Embodiment

With reference to Figure 1, a proximity sensor 10 has a proximity sensing circuit 11 of any one of a number of conventional types, such as an inductive type which detects the presence of a ferro-magnetic object. In response to detecting the object's presence, proximity sensing circuit 11 produces an active output voltage across terminals 12 and 14. Although the present invention is described in the context of a proximity sensor, it is understood that the inventive concepts can be employed with other types of apparatus that have optically isolated output stages.

The output terminals 12 and 14 of the proximity sensor 10 are connected to inputs of a conventional photovoltaic MOSFET driver 16, such as model DIG-11-8-30-DD manufactured by Dionics Inc. MOSFET drivers provide optical isolation between an input circuit, in this case the proximity sensing circuit 11, and an output stage 22. Such drivers are specifically designed for use with metal oxide semiconductor field effect transistors (MOSFET) which consume virtually no gate current. The photovoltaic MOSFET driver 16 uses current from proximity sensing circuit 11 to generate light which illuminates internal photovoltaic diodes that generate the gate bias voltage from the light energy. A photovoltaic MOSFET driver 16 does not switch a voltage from an external source, but actually generates the bias voltage by converting the light energy into electricity. Therefore, when MOSFET driver 16 receives an input current from terminals 12 and 14 of the proximity sensing circuit, a positive voltage level is produced at a first output connector 18 with respect to a second output connector 19.

The output connectors 18 and 19 of MOSFET driver 16 are connected to the output stage 22. In particular, a relatively large value resistor 23 is connected across the output connectors 18 and 19 of MOSFET driver 16. The first output connector 18 is connected to the gate electrode of a MOSFET 24 having its drain electrode connected to the positive output terminal 25 of the proximity sensor 10 and its source electrode connected to node 26. A current sensing resistor 28 is connected between node 26 and a negative output terminal 30 for the proximity sensor 10. The negative output terminal 30 also is connected directly to the second output connector 19 of the MOSFET driver 16.

As will be described, the voltage across current sensing resistor 28 corresponds to the magnitude of current flowing through the MOSFET 24 between the positive and negative output terminals 25 and 30. Node 26 in this current path is connected by resistor 32 to an intermediate node 34 which in turn is coupled by capacitor 36 to the negative output terminal 30. Intermediate node 34 is connected to the base of a first transistor 38 having an emitter which is connected to the negative output terminal 30. The collector of the first transistor 38 is coupled to the gate of MOSFET 24 by a resistor 42, a capacitor 44 and the base-to-emitter junction of a second transistor 40 which are connected in parallel. Capacitors 36 and 44 provide noise suppression for the circuit. The second transistor 40 has an emitter connected directly to the gate of the MOSFET 24, a collector connected to intermediate node 34 and its base connected to the collector of the first transistor 38. The interconnection of the two transistors 38 and 40 is a two transistor analogue of a conventional silicon controlled rectifier, SCR. As will be described, this pair of transistors operates in a similar manner to an SCR in that once turned on, they remain conductive until the current flowing thought them drops to zero, thus forming a latching switch. This latching is an important characteristic for the short circuit protection.

During normal operation of the proximity sensor 10, the MOSFET driver 16 solely controls the conductivity state of MOSFET 24. Specifically, when the proximity sensing circuit 11 activates the MOSFET driver 16, the latter component generates a positive voltage at output connector 18 which biases the gate of MOSFET 24 positive thereby turning on the transistor. When the MOSFET driver 16 is not activated by the proximity sensing circuit 11, the bias voltage is removed from the gate of MOSFET 24 which turns off the transistor. In the conductive state, current from an external source flows between the positive and negative output terminals 25 and 30 and powers an external load. Thus, the proximity of the member detected by sensor 10 controls that load. In this normal operating mode, the current flow between output terminals 25 and 30 is of a magnitude that is insufficient to activate the short circuit protection circuit within output stage 22.

Assume now that a short circuit occurs in the external circuitry connected to the output terminals 25 and 30 so that a relatively large current flows between those terminals when the MOSFET 24 is in a conductive state. In this situation, the current through the current sensing resistor 28 rises above a threshold level determined by the value of resistor 28 and the V_{BE} of the first transistor 38. For example, the output current threshold is 5.3 amperes. When this current threshold is exceeded, the short circuit protection circuit becomes activated.

At that point, the voltage at node 34 rises to a level at which the first transistor 38 begins to conduct drawing current through both resistor 42 and the base of the second transistor 40. This operation removes the voltage from the gate of MOSFET 24 thereby turning off the MOSFET before it can be damaged by the short circuit current. 1 The current into the base of first transistor 38 is amplified by the current gain of that transistor. At this time, current also starts to flow into the base of the second transistor 40. By using relatively high current gain transistors 38 and 40 (e.g. a total gain of about 90,000), very little current is required into the base of first transistor 38 in order for both of the transistors 38 and 40 to saturate. Current from the collector of the second transistor 40 flows into the base of the first transistor 38 causing the transistors to become latched. Thereafter, current through resistor 32 is not required in order to maintain transistors 38 and 40 in a conductive state and the transistors remain latched-on until the current from the MOSFET driver 16 is removed. Once the short circuit has been corrected, the proximity sensor 10 can be reset manually or automatically by deactivating the MOSFET driver 16 to remove the current supplied through output connector 18 thus turning off transistors 38 and 40.

In the latched state, the latching switch formed by transistors 38 and 40 consumes very little current from the output of the MOSFET driver 16. This is important because the photovoltaic MOSFET driver 16 is capable of supplying only a very small amount of current 16, for example a maximum of 20-30 micro-amperes. Previous short circuit protection mechanisms require much higher current levels and thus are not suitable for use with a photovoltaic optical isolator, such as MOSFET driver 16. Therefore, the high current gain and unique design of the present protection circuit makes it well suited for such applications.

## Claims

1. An output stage (22) for an electronic apparatus (10) which controls external circuitry connected thereto, said output stage comprising:
first and second output terminals (25,30) to which the external circuitry is to be connected;
a current sensing resistor (28);
a power transistor (24) having a conduction path coupled in series with said current sensing resistor (28) between the first and second output terminals (25,30), said power transistor (24) having a control electrode;
an optical isolator (16) having an input (12,14) and an output (18) that is connected to the control electrode of said power transistor (24), and responding to a signal applied to the input by producing a bias voltage at the output;
a first resistor;
a latching switch (38,40) coupled in series with said first resistor (42) between the control electrode of said power transistor (24) and said second output terminal (30), and having a control terminal coupled to a connection (26) between said power transistor (24) and said current sensing resistor (28), wherein said latching switch (38,40) is rendered conductive by a voltage across said current sensing resistor (28) exceeding a threshold level and thereafter remaining conductive as long as said optical isolator (16) applies the bias voltage to the control electrode of said power transistor (24).

2. The output stage (22) as recited in claim 1 further comprising a second resistor (32) coupling the control terminal of said latching switch (38,40) to the connection between said power transistor (24) and said current sensing resistor (28).

3. The output stage (10) as recited in claim 1 wherein said power transistor (24) is a MOSFET; and said optical isolator (16) is a photovoltaic MOSFET driver.

4. The output stage (22) as recited in claim 1 wherein said latching switch (38,40) comprises:
a first transistor (38) having a first base electrode forming the control terminal, and having a first emitter-collector conduction path in series with said first resistor (42); and
a second transistor (40) having a second base electrode coupled to a connection between said first transistor (38) and said first resistor (42), and having a second emitter-collector conduction path connected between the control electrode and the first base electrode.

5. The output stage (22) as recited in claim 4 further comprising a second (32) resistor coupling the first base electrode to the connection between said power transistor (24) and said current sensing resistor (28).

6. An output stage (22) for an electronic apparatus (10) which controls external circuitry connected thereto, said output stage comprising:
first and second output terminals (25,30) to which the external circuitry is to be connected;
a current sensing resistor (28);
a metal oxide semiconductor field effect transistor (24) having a conduction path coupled in series with said current sensing resistor (28) between the first and second output terminals (25,30), and having a control electrode;
a photovoltaic driver (16) having an input (12,14) and an output (18) optically isolated from each other with the output connected to the control electrode, and responding to a signal applied to the input by generating a bias voltage at the output;
a node (41);
a first transistor (38) having a first base electrode coupled to a connection (26) between said metal oxide semiconductor field effect transistor (24) and said current sensing resistor (28), and having a first emitter-collector conduction path connected between said node (41) and the second output terminal (30);
a first resistor (42) connected between said node (41) and the control electrode of said metal oxide semiconductor field effect transistor (24); and
a second transistor (40) having a second base electrode connected to said node (41) and having a second emitter-collector conduction path connected between the control electrode and the first base electrode.

7. The output stage (22) as recited in claim 6 further comprising a second resistor (32) coupling the first base electrode of said first transistor (38) to the connection (26) between said metal oxide semiconductor field effect transistor (24) and said current sensing resistor (28).

8. The output stage (22) as recited in claim 7 further comprising a capacitor (36) connected between the first base electrode of the first transistor (38)and said second output terminal (30).

9. The output stage (22) as recited in claim 6 further comprising a capacitor (44) coupled in parallel with said first resistor (44).

10. A proximity sensor (10) comprising:
first and second output terminals (25,30);
a proximity sensing circuit (11) for detecting presence of an object and in response thereto producing a first signal;
an optical isolator (16) having an input (12,14) connected to said proximity sensing circuit (11) for receiving the first signal, and having first and second output connectors (18,19) across which said optical isolator (16) produces a bias voltage in response to the first signal, the second output connector (19) being coupled to said second output terminal (30);
a current sensing resistor (28);
a power transistor (24) with a conduction path in series with said current sensing resistor (28) between the first and second output terminals (25,30), and having a control electrode connected to the first output connector (18) of said optical isolator (16);
a node (41);
a first transistor (38) having a first base electrode, and a first emitter-collector conduction path connected between said node (41) and the second output terminal (30);
a first resistor (42) connected between said node (41) and the control electrode of said power transistor (24); and
a second resistor (32) coupling the first base electrode to a connection (26) between said power transistor (24) and said current sensing resistor (28); and
a second transistor (40) having a second base electrode connected to said node (41) and having a second emitter-collector conduction path connected between the control electrode of said power transistor (24) and the first base electrode.

11. The proximity sensor (10) as recited in claim 10 further comprising a capacitor (36) connected between the first base electrode and said second output terminal (30).

12. The proximity sensor (10) as recited in claim 10 further comprising a capacitor (44) coupled in parallel with said first resistor.

13. The proximity sensor (10) as recited in claim 10 further comprising another resistor (23) connected across the first and second output connectors (18,19) of said optical isolator (16).

14. The proximity sensor (10) as recited in claim 10 wherein said power transistor (24) is a metal oxide semiconductor field effect transistor; and said optical isolator (16) is a photovoltaic MOSFET driver.
